# EUROPEAN PATENT APPLICATION

(11) **EP 3 264 444 A1**
(43) Date of publication of application: **03.01.2018**
(21) Application number: 17180354.7
(22) Date of filing: 15.02.2007
(51) Int. Cl.: H01L 21/027, G02B 13/14, G02B 13/24, G02B 17/06, G03F 7/20, G02B 5/08

(54) **PROJECTION OPTICAL SYSTEM, EXPOSURE APPARATUS AND METHOD FOR MANUFACURING SEMICONDUCTOR DEVICE**

(30) Priority: 10.03.2006 JP 2006066583
(62) Divisional of application: 07714302.2
(71) Applicant: Nikon Corporation, Minato-ku, Tokyo 108-6290 (JP)
(72) Inventor: Murakami, Katsuhiko, Tokyo, 100-8331 (JP); Komiya, Takaharu, Tokyo, 100-8331 (JP)
(74) Representative: Hooiveld, Arjen Jan Winfried

(57) **Abstract**

A projection optical system in which OoB irradiation dose on a wafer is reduced while degradation in optical characteristics is suppressed. The projection optical system comprises a first reflecting mirror exhibiting a reflectivity lower than a predetermined value to a second wavelength light different from a predetermined first wavelength light, and a second reflecting mirror exhibiting a reflectivity higher than the predetermined value to the second wavelength light. When the reflecting mirrors in the projection optical system is classified as reflecting mirrors (M1 M2, M5, M6) having a high ratio of overlapped reflection regions corresponding to two different points on the wafer, and reflecting mirrors (M3, M4) having a low ratio of overlapped reflection regions the uppermost stream reflecting mirror (M3) in the optical path of the projection optical system out of reflecting mirrors having a low ration of overlapped reflection regions is the second reflecting mirror.

## Description

### Technical Field

The inventions relate to projection optical system, exposure apparatus comprising a projection optical system and a semiconductor device manufacturing method using the exposure apparatus.

### Background Art

At present, reduction projection-exposure methods that achieve high processing speeds are widely used in the manufacture of semiconductor integrated circuits. In recent years, with ongoing miniaturization of semiconductor integrated-circuit elements, projection lithography using soft X-rays having shorter wavelengths (0.5 to 50 nm) than conventional ultraviolet light, has been developed. Soft X-rays improve the resolving power of optical systems that otherwise are limited by diffraction of light, as described in Tichenor et al., Proceedings SPIE 2437:292 (1995). Soft X-ray lithography is also called EUV (extreme ultraviolet) lithography (abbreviated EUVL), which is the name most commonly used now. EUVL is expected to become the lithography technology of the future, offering resolving powers of 50 nm or less. Such resolution currently is not possible using conventional photolithography performed using wavelengths of approximately 190 nm or greater. Because the index of refraction of materials is very close to one in the EUVL wavelength range, conventional optical elements used for refraction and reflection cannot be used. Consequently, grazing-incidence mirrors (providing total reflection due to their index of refraction being slightly less than 1) and multilayer-film reflecting mirrors (which combine and superpose multiple phases of light weakly reflected at layer interfaces) are used. The obtained reflectance is sufficiently high to be useful

An EUV light source used in an EUVL apparatus radiates light of various wavelengths in addition to EUV wavelengths. Many of the wavelengths (e.g., ultraviolet light, visible light, infrared light, and the like having wavelengths longer than EUV wavelengths) are different from actual EUV light used for exposures. These non-exposure wavelengths are called OoB (out of band) light. If exposure light includes OoB light, the following problems generally occur:
(1) The OoB wavelengths expose the EUV optical systems to excess radiant energy. Absorption of this excess energy by reflecting mirrors of the projection optical system causes the reflecting mirrors to exhibit thermal aberrations (e.g., aberrations caused by heat-deformation of the reflecting mirror). These aberrations deteriorate the image quality of the projection optical system.
(2) The resist on the wafer to be lithographically exposed have some sensitivity to OoB light. Hence, when certain wavelengths of OoB light (e.g., ultraviolet light and the like) reach the wafer, they produce background exposure "noise." This noise does not help resolve the lithographic pattern on the wafer, has the same effect as flare in photolithography optical systems, reduces the contrast of the lithographic image, and actually deteriorates the resolving power of the EUV optical system.
(3) In addition to providing no beneficial contribution to the EUV lithographic exposure, OoB light reaching the wafer causes heating of the wafer, with consequent thermal expansion of the wafer. Thus, alignment precision of the wafer is degraded and distortion is increased.

Usually, a filter is used to block OoB light. An exemplary OoB-light-blocking filter suitable for use in the EUV-wavelength region is a free-standing film (membrane) type filter. The membrane filter is a very thin (1 micrometer or less) layer of beryllium (Be), zirconium (Zr), or the like, as described in Japan Kokai Patent Document No. 2003-14893, for example. Unfortunately, such membrane-type filters are very fragile, are difficult to make in large diameters, and exhibit low transmission of EUV light (approximately 50% or less).

A multilayer-film reflecting mirror, which suppresses reflection of OoB light, has been proposed for use as an OoB filter in place of the conventional membrane-type filter, as described in Japan Kokai Patent Document No. Hei 6-148399, for example. The multilayer-film reflecting mirror includes an antireflective layer, disposed on the topmost layer of the multilayer film, to prevent reflection of incident OoB light.

### Disclosure of the Invention

### Problems to be Solved by the Invention

The multilayer-film reflecting mirror with an antireflective layer for OoB light not only absorbs more OoB light than a conventional multilayer-film reflecting mirror but also absorbs EUV light. Consequently, when using such a reflecting mirror, the intensity of EUV produced by the source must be correspondingly greater to have the same illuminance of EUV light on the wafer otherwise obtained when using a conventional multilayer-film filter. Thus, using the EUV projection optical system with more intense EUV light causes more thermal deformation of the system, increases the aberrations of the system, and degrades the optical properties of the system.

Consequently, there is a need for projection optical system that provides reduced OoB radiation on the wafer and that exhibit less deterioration of their optical properties.

### Means for Solving the Problems

A projection optical system according to the present invention project an image of a pattern on a first plane onto a second plane. An embodiment of such a system comprises a first reflecting mirror that has a reflectance for light, of a predetermined wavelength, that is less than a predetermined reflectance. The embodiment also comprises a second reflecting mirror that has a reflectance for light, of the predetermined wavelength, that is greater than the predetermined reflectance. The first reflecting mirror is positioned, along a light-propagation path extending from the first plane to the second plane, closer than the second reflecting mirror to the first plane.

According to the invention, by positioning the first reflecting mirror in this manner on the first-plane side of the light-propagation path, the first reflecting mirror absorbs sufficient light of the predetermined wavelength, which reduces the influence of the light of predetermined wavelength on the reflecting mirror that is positioned closer to the second plane than the first reflecting mirror.

A projection optical system according to the present invention projects an image of pattern from a first plane onto a second plane. The system comprises a first reflecting mirror that has a reflectance for light, of a predetermined wavelength, that is less than a predetermined reflectance. The system also comprises a second reflecting mirror that has a reflectance for light, of the predetermined wavelength, that is greater than the predetermined reflectance. Among the reflecting mirrors of this projection optical system, the reflecting mirror situated at a position at which illuminance is highest is the second reflecting mirror.

According to the invention, with this configuration, deformation of the reflecting mirror having the greatest absorption per unit area is reduced because the reflecting mirror situated where illuminance is highest is the second reflecting mirror.

A projection optical system according to the present invention projects an image of a pattern from a first plane onto a second plane. The system comprises a first reflecting mirror that has a reflectance for light, of a predetermined wavelength, that is less than a predetermined reflectance. The system also comprises a second reflecting mirror that has a reflectance for light, of the predetermined wavelength, that is greater than the predetermined reflectance. Along the light-propagation path extending from the first plane to the second plane, the second reflecting mirror is located in the vicinity of a location at which an intermediate image of the pattern is formed.

In this optical system, since a light beam is focused in the vicinity of the location of the intermediate image of the pattern, the illuminance of the reflecting mirror situated in that vicinity is high. According to the invention, by placing a second reflecting mirror at this vicinity, the radiant energy per unit area absorbed by the reflecting mirror is reduced even at high illuminance, which reduces thermal deformation of the reflecting mirror.

A projection optical system according to the present invention projects an image of a pattern on a first plane onto a second plane. The system comprises a first reflecting mirror that has a reflectance for light of a predetermined wavelength, that is less than a predetermined reflectance. The system also comprises a second reflecting mirror that has a reflectance for light, of the predetermined wavelength, that is greater than the predetermined reflectance. In this embodiment a first point-reflecting region is a region in which a light beam collected at a predetermined first point on the second plane is reflected on a reflecting mirror, a second point-reflecting region is a region in which a light beam collected at a second point, different from the first point, on the second plane is reflected on a reflecting mirror, and a common-reflecting region is a region in which the first point-reflecting region and the second point-reflecting region overlap. Among the reflecting mirrors of the system in which the percentage of the common-reflecting region corresponding to the first point-reflecting region is lower than a predetermined percentage, the reflecting mirror positioned closest to the first plane, along the light-propagation path from the first plane to the second plane, is the second reflecting mirror.

Reflecting mirrors in which the percentage of the common-reflecting region corresponding to the first point-reflecting region is higher than the predetermined percentage can accommodate thermal deformation caused by radiant heat, as described later. In comparison, it is more difficult for reflecting mirrors, in which the percentage of the common-reflecting region corresponding to the first point-reflecting region is lower than the predetermined percentage, to accommodate the thermal deformation caused by radiant heat. This embodiment reduces deformation of the reflecting mirrors that do not easily accommodate thermal deformation from radiant heat because the reflecting mirror, among the reflecting mirrors in which the percentage of the common-reflecting region corresponding to the first point-reflecting region is lower than the predetermined percentage, that is positioned closest to the first plane is the second reflecting mirror.

A projection optical system according to the present invention projects an image of a pattern on a first plane onto a second plane. The system comprises a first reflecting mirror and a second reflecting mirror that has a reflectance for light of the predetermined wavelength, that is greater than a reflectance of the first reflecting mirror for light of the predetermined wavelength. According to the invention, deterioration of the optical properties can be made less.

A projection optical system according to the present invention projects an image of a pattern on a first plane onto a second plane. The system comprises plural reflecting mirrors for reflecting exposure light between the first plane and the second plane. In this embodiment, the reflecting mirrors comprise a first reflecting mirror which has a mechanism to reduce lights having a wavelength different from the exposure light and reaching a reflecting mirror situated on the second plane side along a light-propagation path from the first plane to the second plane or the second plane and a second reflecting mirror which does not have the mechanism. Along the light-propagation path from the first plane to the second plane, the reflecting mirror situated closest to the first plane is the first reflecting mirror.

According to the invention, lights having a wavelength different from the exposure light and reaching the reflecting mirrors other than the reflecting mirror situated closest to the first plane, are reduced, because the reflecting mirror situated closest to the first plane is the first reflecting mirror. Accordingly, effects of the lights having a wavelength different from the exposure light on the reflecting mirrors other than the reflecting mirror situated closest to the first plane, are reduced.

An exposure apparatus according to the present invention comprises any of the projection optical system summarized above.

With the exposure apparatus according to the present invention, effects of lights of predetermined wavelengths on the wafer can be made small while deformation of reflecting mirrors is kept small.

A method for manufacturing a semiconductor device according to the present invention, has a process in which exposure for transfer is performed using the exposure apparatus according to the present invention.

According to the method, effects of lights of predetermined wavelengths on the wafer can be made small while deformation of reflecting mirrors is kept small. Consequently, a semiconductor device can be manufactures with higher accuracy.

By including at least one first reflecting mirror and at least one second reflecting mirror in a projection optical system, involving consideration of the manner in which light is reflected by each of the reflecting mirrors in the system, and by appropriate determination of the particular reflecting mirror(s) to be configured as a first reflecting mirror and of the particular reflecting mirror(s) to be configured as a second reflecting mirror, a projection optical system is provided with which OoB illuminance on the wafer is reduced while deterioration of optical properties of the system is kept small.

### Brief Description of the Drawings

FIG. 1 shows exemplary regions at which light is reflected on each reflecting mirror M1, M2, M3, M4, M5, M6 of a projection optical system.
FIG. 2 shows a light beam, reflected by reflecting mirrors M5 and M6, being collected at a predetermined point on the wafer surface.
FIG. 3 shows a relationship between the exposure region on the wafer surface and the corresponding reflecting region and common reflecting region on the reflecting mirror.
FIG. 4 shows a method for adjusting the reflecting mirrors.
FIG. 5 is a schematic diagram of an EUV exposure apparatus comprising multilayer-film reflecting mirrors.
FIG. 6 shows an exemplary configuration of the first reflecting mirror.
FIG. 7 shows an exemplary configuration of another type of first reflecting mirror.
FIG. 8 shows an exemplary configuration of the second reflecting mirror.
FIG. 9 shows an exemplary configuration of a reflecting mirror-cooling apparatus.
FIG. 10 is an exemplary process-flow diagram of a method for manufacturing a semiconductor device, according to an embodiment of the invention.

### Best Mode for Carrying Out the Invention

Embodiments of the present invention are described below with reference to the drawings. As used herein, a reflecting mirror having a low reflectance for light of a predetermined wavelength (for example, light of a predetermined wavelength of OoB light) is called a "first reflecting mirror," and a reflecting mirror having a high reflectance for light of the predetermined wavelength is called a "second reflecting mirror."

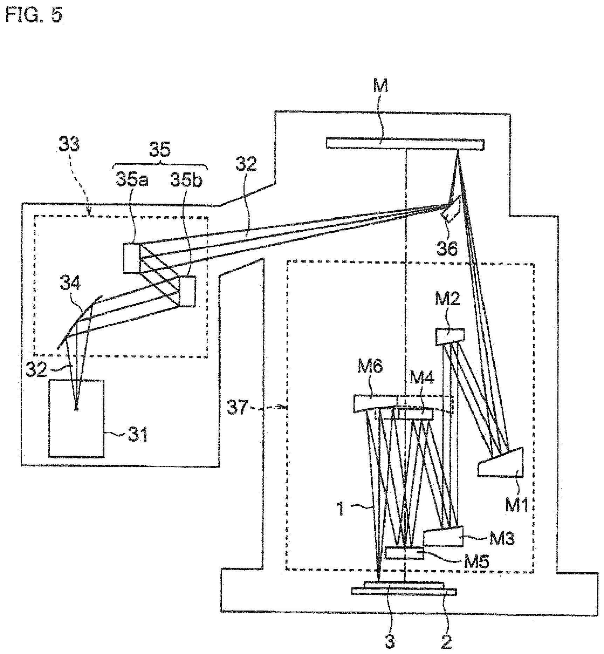

FIG. 5 depicts an exemplary EUV exposure apparatus that uses multilayer-film reflecting mirrors.

The beam **32** (EUV light in the embodiment) is radiated from a light source **31** and is nearly collimated by reflection from a concave reflecting mirror **34** serving as a collimator mirror, in an illumination-optical system **33.** The beam **32** enters an optical integrator **35** comprising a pair of fly-eye mirrors **35*a*, 35*b*.** The reflective surface of the fly-eye mirror **35*a*** (i.e., the vicinity of the radiating surface of the optical integrator **35**) effectively forms a source of substantially planar light having a predetermined form. Light from this substantially planar light source is deflected by a planar reflecting mirror **36** and is incident on the mask M as a long, thin, arc-shaped illuminated region. An aperture plate for forming the arc-shaped illuminated region is not shown.

The projection light **1** reflected from the surface of the mask M is reflected in order by multilayer-film reflecting mirrors M1, M2, M3, M4, M5, M6 of the projection-system **37.** The projection light 1 thus projects an image of the illuminated mask pattern, formed on the surface of the mask M, onto a layer of resist **3** applied to a wafer **2.** Thus, the projection optical system **37** projects an image of the pattern of a first plane (in this embodiment, the surface of the mask, termed "mask surface") onto a second plane (in this embodiment, the surface of the resist layer on the wafer, termed "wafer surface"). In the projection optical system shown in FIG. 5, an intermediate image of the pattern is formed in the vicinity of the reflecting mirror M3, between the reflecting mirrors M3 and M4. Along the light path from the first plane to the second plane, the first-plane side is called "upstream," and the second-plane side is called "downstream."

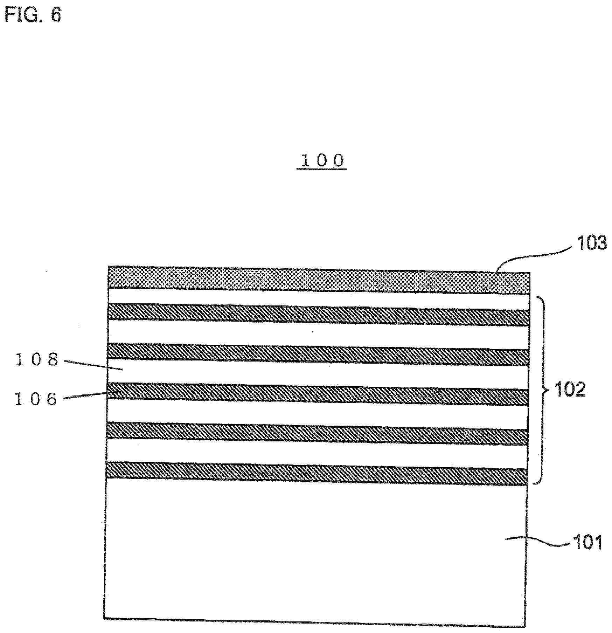

FIG. 6 is a schematic section of an exemplary first reflecting mirror **100.** A multilayer EUV light-reflecting film **102** is formed on a substrate **101** comprising quartz or low-thermal-expansion glass. An OoB light-absorbing film **103** is formed on the surface of the multilayer film 102. The EUV light-reflecting film **102** comprises forty layer pairs, wherein each layer pair comprises a respective Mo layer **106** and a respective Si layer **108.** The thickness of the Mo layer **106** is 2.4 nanometers, for example, and the thickness of the Si layer **108** is 4.5 nanometers, for example. The EUV light-reflecting film **102** may be a laminate of any two or more of the following materials: molybdenum (Mo), silicon (Si), ruthenium (Ru), rhodium (Rh), beryllium (Be), silicon oxide, or the like.

The OoB light-absorbing film **103** is at least one layer comprising one or more of the following materials, or a mixture of any of these materials: silicon oxide (SiO), carbon (C), zirconium (Zr), silicon carbide (SiC), silicon nitride (Si₃N₄), boron carbide (B₄C), and boron nitride (BN). For example, the OoB light-absorbing film **103** comprises plural such layers (two such layers, for example). Since the OoB light-absorbing film **103** absorbs mainly OoB light, the reflectance to OoB light of the first reflecting mirror having an OoB light-absorbing film **103** can be made less than a predetermined level by adjustment of the thickness of the OoB light-absorbing film **103.** When the thickness of the OoB light-absorbing film **103** is less than one nanometer, the effectiveness with which the film absorbs OoB light becomes insufficient, allowing the OoB light to affect the downstream reflecting mirrors as well as the wafer. If the thickness of the OoB light-absorbing film **103** is greater than 50 nm, the film tends to absorb an excessive amount of incident EUV light. Hence, the thickness of the OoB light-absorbing film desirably is in the range of 1 to 50 nm. Regarding the first reflecting mirror **100,** its reflectance to OoB light desirably is less than its reflectance to EUV light. More desirably, its reflectance to OoB light is 0 to 40%, and even more desirably is 0 to 10%.

The OoB light-absorbing film **103** can suppress oxidation of the EUV light-reflecting film **102.** If further oxidation suppression is desired, an oxidation-suppressing film may be interposed between the EUV light-reflecting film **102** and the OoB light-absorbing film **103,** or alternatively on the surface of the OoB light-absorbing film **103.** The oxidation-suppressing film comprises at least one layer of any of the following or of an alloy thereof: ruthenium (Ru), rhodium (Rh), niobium (Nb), and platinum (Pt). For example, the oxidation-suppressing film can comprise plural such layers (two such layers, for example).

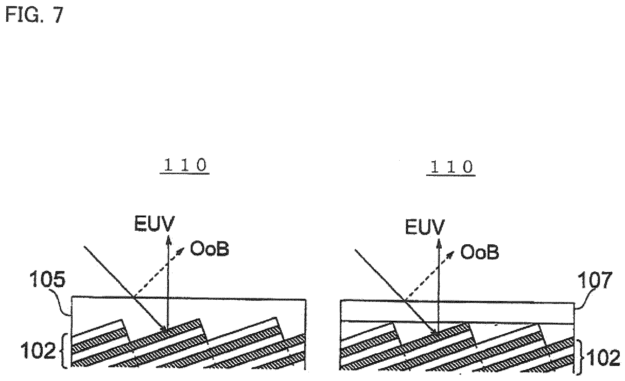

As an alternative to the first reflecting mirror **100** with the OoB light-absorbing film **103** for absorbing OoB light, another type of reflecting mirror can be used for suppressing OoB light. The alternative reflecting mirror **110** is shown in FIG. 7, and comprises an additional layer **105** or membrane **107** on the EUV light-reflecting film **102.** The layer **105** or membrane **107** comprises a material selected from silicon (Si), silicon carbide (SiC), silicon nitride (Si₃N₄), or the like. The thickness of the layer 105 or membrane **107** is approximately 0.05 to one micrometer, for example. The layer **105** or membrane **107** absorbs very little EUV light. The reflecting mirror **110** is configured such that the reflective surface of the EUV light-reflecting film **102** is not parallel to the reflective surface of the layer **105** or membrane **107.** Rather, the reflective surface of the EUV light-reflecting film is inclined at a predetermined angle relative to the reflective surface of the layer **105** or membrane **107.**

EUV light incident to the first reflecting mirror **110** is reflected by the reflective surface of the EUV light-reflecting film **102** and arrives either at a downstream reflecting mirror or at the wafer. Meanwhile, the OoB light is reflected in a different direction from the reflection direction of the EUV light by the reflective surface of the layer **105** or membrane **107.** The reflected OoB light goes out of the propagation path of the EUV light and does not reach either a downstream reflecting mirror or the wafer. The angle formed by the reflective surface of the EUV light-reflecting film **102** relative to the reflective surface of the layer **105** or membrane **107** is approximately 5 to 30 degrees, for example. The reflecting mirror **110** exhibits a low reflectance to OoB light, as seen from downstream along the propagation path of EUV light. In view of these properties, the reflecting mirror **110** is called a "first" reflecting mirror. To absorb OoB light going out of the propagation path of EUV light, a material having a high index of absorption for OoB light may be mounted in reflection direction of the OoB light. This high-index material can be a porous form of carbon black, activated charcoal, or the like.

The "first" reflecting mirrors described above exhibit a slight decrease in reflectance to EUV light, compared to "second" reflecting mirrors discussed below. But, the first reflecting mirrors exhibit a greatly reduced reflectance to OoB light (for example, one-tenth or less) compared to conventional EUV reflecting mirrors.

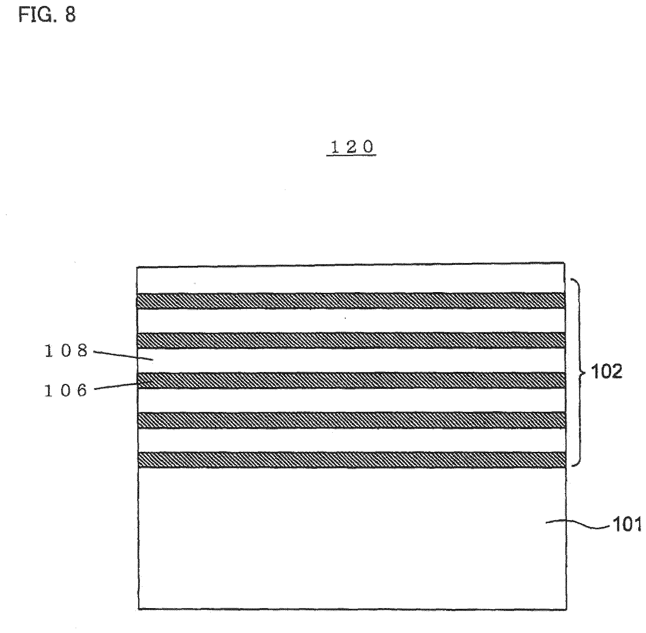

FIG. 8 depicts an exemplary "second" reflecting mirror. The second reflecting mirror **120** comprises an EUV light-reflecting film **102** formed on a substrate **101** made of quartz or low-thermal-expansion glass. The EUV light-reflecting film **102** is a multilayer film comprising 40 layer-pairs in this example. Each layer-pair comprises a respective Mo layer **106** and a respective Si layer **108.** By way of example, the thickness of the Mo layer **106** is 2.4 nanometers, and the thickness of the Si layer **108** is 4.5 nanometers. The EUV light-reflecting film **102** may be a laminate of two or more of the following materials: molybdenum (Mo), silicon (Si), ruthenium (Ru), rhodium (Rh), beryllium (Be), silicon oxide, or the like. To reduce oxidation of the EUV light-reflecting film **102,** an oxidation-suppressing film may be formed on or applied to the surface of the EUV light-reflecting film **102.** The oxidation-suppressing film comprises at least one layer of any of the following materials or of an alloy thereof: ruthenium (Ru), rhodium (Rh), niobium (Nb), and platinum (Pt). For example, the oxidation-suppressing film can comprise plural such layers (two such layers, for example).

The first and second reflecting mirrors absorb light and radiant heat, causing an increase in temperature of the reflecting mirrors. As temperature increases, as discussed above, the reflecting mirrors tend to deform and contribute aberrations to the optical system. A reflecting mirror cooling device may be installed to suppress these temperature increases in the reflecting mirrors.

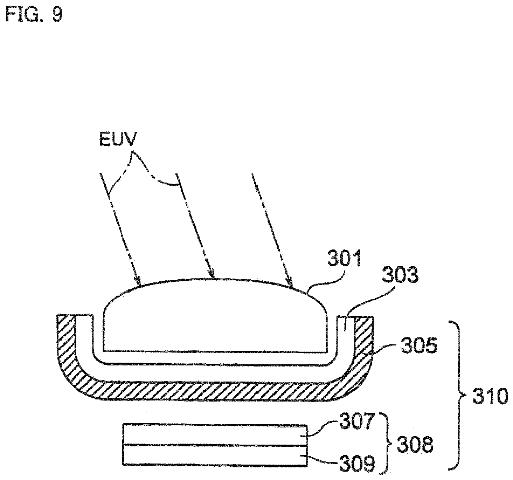

An example embodiment of a reflecting mirror cooling device is shown in FIG. 9. The reflecting mirror cooling device comprises a first heat-receiving plate **303** situated on the perimeter of and outside the reflective surface of a reflecting mirror **301.** A cooling mechanism **305** is coupled to and established on the perimeter of the first heat-receiving plate **303.** A thermal insulator **308** is situated at a defined distance from the cooling mechanism **305.** The first heat-receiving plate **303** is a thin ceramic or metal plate having a high emissivity and photothermal conductivity to draw heat from the reflecting mirror **301.** The cooling mechanism **305** comprises a heat pipe and cooling jacket, and absorbs heat received by the first heat-receiving plate **303.** The thermal insulator **308** comprises a heating device **307** comprising a heat pipe and a second heat-receiving plate **309.** The first heat-receiving plate **303** and cooling mechanism **305** prevent transmission of thermal effects to other reflecting mirrors or the like.

Optical properties of a projection optical system comprising various combinations of first reflecting mirrors and second reflecting mirrors are described below.

Tables 1-6 list data such as radiation dose, absorption dose, illuminance, absorption, and the like, of incident EUV light, of incident OoB light, and of both, for each reflecting mirror in the projection optical system. The "effective area" is the area of the region on the reflecting mirror surface from which light is reflected. The "illuminance" is the radiation dose divided by the effective area. The "absorption" is the absorption dose divided by the effective area. With first reflecting mirrors, the reflectance for EUV light is 60%, and the reflectance for OoB light is 10%. With second reflecting mirrors, the reflectance for EUV light is 65% and the reflectance for OoB light is 80%. In the following tables, reflecting mirrors (from among reflecting mirrors M1-M6) used as "first" reflecting mirrors are denoted with an asterisk: Mi* (wherein i=l to 6).

Table 1 lists data such as the radiation dose, absorption dose, illuminance, absorption, and the like, of EUV light, of OoB light, and of both lights, for each reflecting mirror in a projection optical system in which all of the reflecting mirrors M1-M6 (FIG. 5) are used as "second" reflecting mirrors. In Table 1, the OoB radiation dose on the wafer is 105 mW.

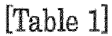

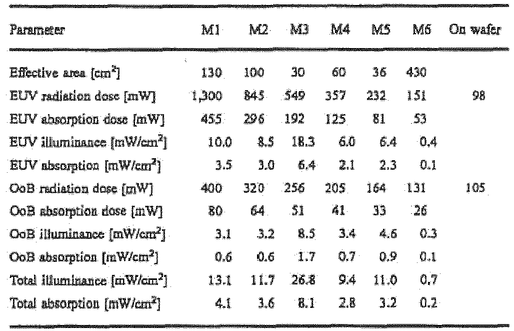

Table 2 lists data such as the radiation dose, absorption dose, illuminance, absorption, and the like, of EUV light, of OoB light, and of both lights, for each reflecting mirror, in a projection optical system in which all of the reflecting mirrors M1-M6 in Fig. 5 are used as "first" reflecting mirrors. In Table 2, the OoB radiation dose on the wafer is 0.001 mW. This value is 0.00095% of the corresponding value of 105 mW shown in Table 1. Thus, with the configuration, the OoB radiation dose on the wafer is greatly reduced as a result of all the reflecting mirrors M1-M6 being first reflecting mirrors.

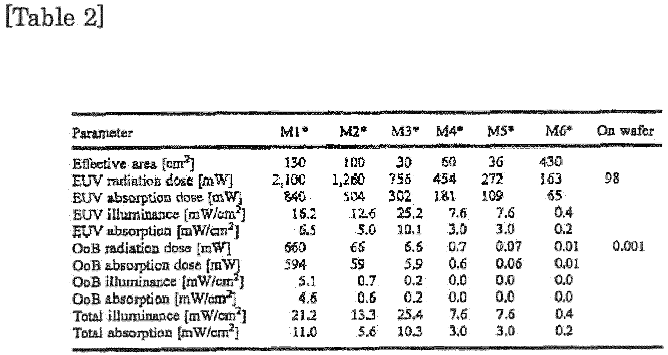

In Table 2, for example, the total absorption by the reflecting mirror M3 is 10.3 mW/cm², which is greater than the corresponding dose of 8.1 mW/cm² in Table 1. The reason for this difference is as follows. First reflecting mirrors not only absorb OoB light better than second reflecting mirrors, but also absorb more EUV light than second reflecting mirrors. Consequently, when a first reflecting mirror is used, the intensity of EUV light entering the reflecting mirror M1 must be higher than when using a second reflecting mirror to produce the same EUV-light illuminance on the wafer that otherwise would be obtained when a second reflecting mirror is used. Therefore, in a system in which all the reflecting mirrors M1-M6 are first reflecting mirrors, the dose of EUV light absorbed by each reflecting mirror in the system is increased. Actually, comparing the data in Table 2 with the data in Table 1, the OoB light-absorption dose of the reflecting mirror M3 is decreased from 51 mW to 5.9 mW, but the EUV light-absorption dose is increased from 192 mW to 302 mW. Thus, as a result of OoB light absorption in the upstream first reflecting mirrors, the total absorbed dose by the system is increased in some instances due to the increase in EUV light absorption, even if the OoB light-absorption dose in a first reflecting mirror is decreased relative to the OoB dose in a second reflecting mirror.

When all the reflecting mirrors M1-M6 are first reflecting mirrors, the total absorption dose of a specific reflecting mirror (reflecting mirror M3 for example) is increased, deformation due to absorbed heat is greater than in a system in which all the reflecting mirrors M1-M6 are second reflecting mirrors, and system aberration is increased. As discussed below, a reflecting mirror such as M3 cannot accommodate aberration caused by thermal deformation. Therefore, the optical properties of the projection optical system in which all the reflecting mirrors M1-M6 are first reflecting mirrors substantially deteriorate compared to systems comprising all second reflecting mirrors. When all the reflecting mirrors M1-M6 are first reflecting mirrors, the OoB radiation dose on the wafer is greatly decreased, but the optical properties of the projection-system are substantially degraded compared to a system comprising all second reflecting mirrors.

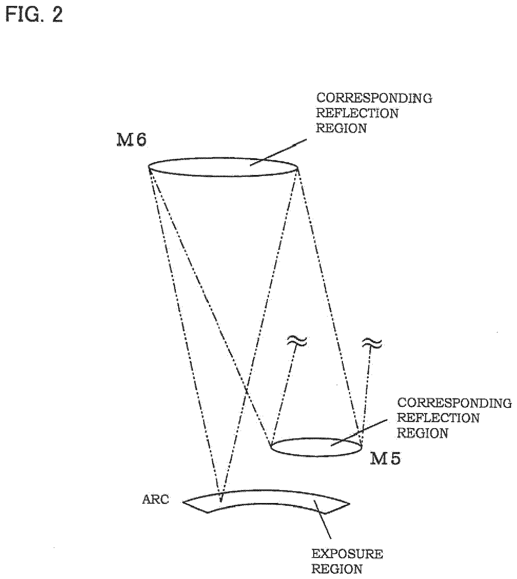

The manner in which light is reflected from each reflecting mirror in the projection optical system is as follows. FIG. 2 shows the typical situation in which a light beam reflected by reflecting mirrors M5 and M6 converges at a predetermined point on the wafer surface. As shown in FIG. 2, it will be understood that a light beam collected at one point in the exposure region on the wafer does not reach the wafer surface from only one direction. Rather, the beam converges on the wafer from three-dimensional space having a point spread, and is reflected by regions on the reflecting mirrors M5, M6 having finite areas. The region on an upstream reflecting mirror at which a light beam, collected at one point of the exposure region on the wafer surface, is reflected is called the "corresponding reflection region." The respective corresponding reflection region on each such reflecting mirror forms an approximate circle on the reflecting surface of the reflecting mirror. Also, for each of two different convergence points in the exposure region, the corresponding reflection regions of the upstream reflecting mirror partially overlap. The overlap region is called the "common reflecting region."

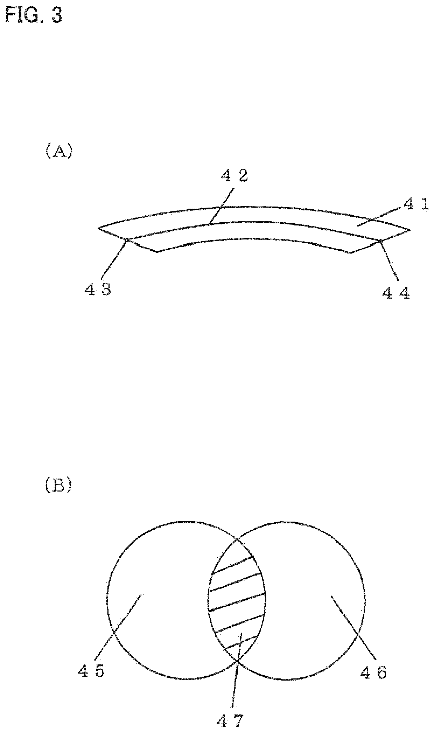

The relationship between the corresponding reflection region and the common reflecting region is illustrated in FIGS. 3(A)-3(B), which show the typical relationship between the exposure region on the wafer surface and the corresponding reflecting region and common reflecting region on the reflecting mirror. In FIG. 3(A), the projection optical system defines an arc-shaped exposure region **41** of predetermined width. A first point **43** is one end of an arc **42** passing through the widthwise center of the arc-shaped exposure region **41,** and the second point **44** is the other end of the arc. In FIG. 3(B), the region from which the light beam collected at the first point **43** is reflected on the upstream reflecting mirror is the denoted as corresponding reflection region **45,** and the region from which the light beam collected at the second point **44** is reflected on the upstream reflecting mirror is denoted as corresponding reflection region **46.** The region **47** in which the regions **45** and **46** overlap is the common reflecting region for the two points **43, 44.** In the foregoing discussion, the relationship between the corresponding reflecting regions and the common reflecting region is described for the two points **43, 44** at respective ends of the arc **42.** However, any two points in the exposure region can be considered in the same way. Also, on the upstream reflecting mirror, the corresponding reflection region corresponding to the entire arc **42** takes a form in which the circles of the corresponding reflection regions continuously shift and overlap.

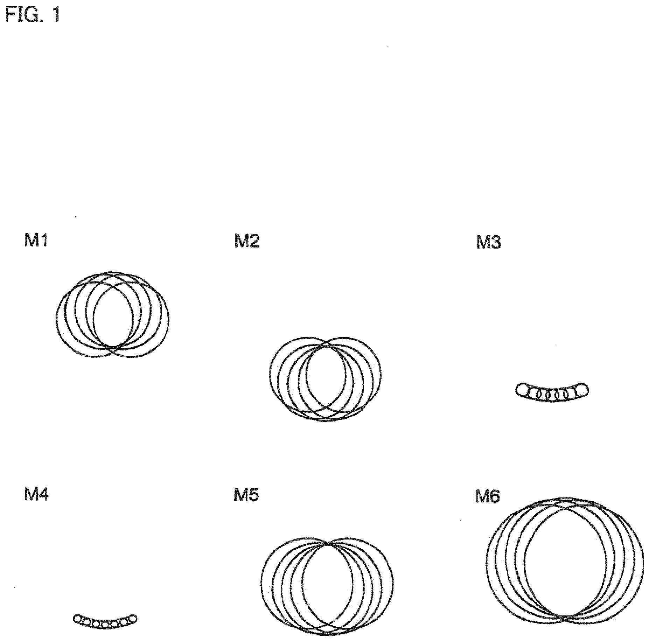

FIG. 1 shows exemplary forms of the region in which light is reflected from the surface of each reflecting mirror M1, M2, M3, M4, M5, M6 in the projection optical system. When the projection optical system defines an arc-shaped exposure region of predetermined width, the region from which light is reflected on each reflecting mirror surface takes a form in which a circle continuously shifts and overlaps as shown in FIG. 1.

In FIG. 1 the reflecting mirrors are divided into one group (reflecting mirrors M1, M2, M5, M6) in which the common reflecting regions occupy a relatively high percentage of the corresponding reflection regions (high common-region percentage) and another group (reflecting mirrors M3, M4) in which the common reflecting regions occupy a relatively low percentage of the corresponding reflection regions (low common-region percentage). A small number of these relationships of common reflecting region relative to corresponding reflecting regions include instances in which the corresponding reflection regions on the upstream reflecting mirror corresponding to two points at opposite ends of the arc-shaped exposure region do not overlap; in these instances the common-region percentage is zero. With respect to reflecting mirrors in which the common-region percentage is low, the common-region percentage pertaining to two points at opposite ends of the arc-shaped exposure region is desirably less than 40%, more desirably 0 to 20%, and still more desirably 0 to 10%.

Radiant-heat deformation of reflecting mirrors in which the common-region percentage is high (e.g., greater than 40%) is of a comparatively low order (i.e., low spatial frequency), such as a change in the radius of curvature of the entire reflecting mirror. This deformation can be accommodated by adjusting the position, or the like, of the reflecting mirrors.

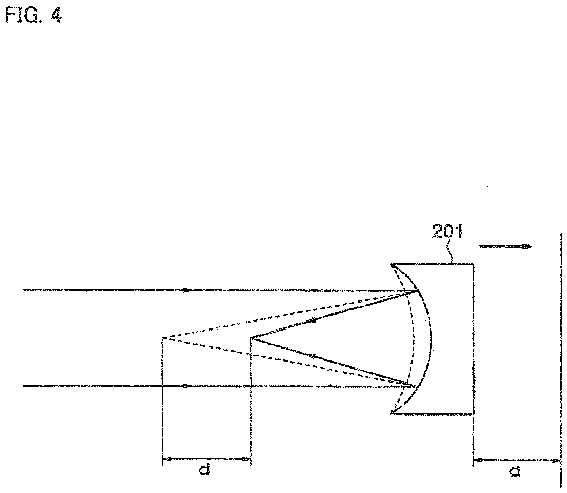

FIG. 4 depicts a typical method for making the adjustment. When a reflecting mirror **201** is deformed as denoted by the dotted line in FIG. 4, the position of its focal point moves to the left (in the figure) by a distance d. To correct the focal point, the reflecting mirror **201** is moved to the right a distance d. Thus, with a reflecting mirror having a high common-region percentage, it is possible to accommodate radiant-heat deformation manifest as a change in the radius of curvature of the reflecting mirror as a whole. The movement distance is appropriately varied according to the magnifying power of the reflecting mirror and the amount of deformation being exhibited by the reflecting mirror.

Radiant-heat deformation of reflecting mirrors in which the common-region percentage is low (e.g., less than 40%) is relatively high-order (i.e., a high spatial frequency), such as a localized deformation of the reflecting mirror surface. This type of deformation cannot be accommodated or corrected by adjusting the position of the reflecting mirror, or the like.

In FIG. 1, for each reflecting mirror M1-M6, the different depicted reflecting regions correspond to the position of respective points in the exposure region on the wafer. On a reflecting mirror having a high common-region percentage, the corresponding reflection regions for the two points at opposite ends of the arc-shaped exposure region overlap. On a reflecting mirror having a low common-region percentage, the corresponding reflection regions do not overlap. For example, consider the respective corresponding reflection regions for the points **43, 44** on the arc **42** in exposure region **41** in FIG. 3. The respective percentages of the common reflecting regions are as follows: 46% for M1, 47% for M2, 0% for M3, 0% for M4, 55% for M5, and 80% for M6. Thus, with a reflecting mirror having a high common-region percentage, radiant-heat deformation causes approximately the same type of deformation at any location in the exposure region. In contrast, with a reflecting mirror having a low common-region percentage, radiant-heat deformation causes very different aberrations at various locations in the exposure region. Hence, since it is difficult to accommodate radiant-heat deformation of a reflecting mirror having a low common-region percentage, it is desirable to make this deformation as small as possible.

In view of the above, a projection optical system according to a first embodiment, has a first reflecting mirror and a second reflecting mirror. The first reflecting mirror has a high common-region percentage and can readily accommodate reflecting mirror deformations caused by radiant heat. The second reflecting mirror has a low common-region percentage and does not easily accommodate radiant-heat deformation. In the system the first reflecting mirror is located closer to the mask surface than the second reflecting mirror. This configuration allows OoB light to be readily absorbed by the first reflecting mirror on the mask-surface side.

For example, among the reflecting mirrors having high common-region percentages and that can accommodate radiant-heat deformations, the reflecting mirror M1 located closest (along the light-propagation path) to the mask surface serves as a first reflecting mirror and absorbs OoB light. The reflecting mirrors M3, M4 having low respective common-region percentages (and that do not easily accommodate radiant-heat deformations) and the reflecting mirrors M2, M5, M6 having high common-region percentages serve as second reflecting mirrors.

The most upstream reflecting mirror M1 normally has a high common-region percentage. Hence, "the most upstream reflecting mirror among the reflecting mirrors having high common-region percentages" is the reflecting mirror that located the most upstream (along the light-propagation path) in the projection optical system. The most upstream reflecting mirror M1 as a first reflecting mirror absorbs sufficient OoB light.

Table 3 lists data such as the radiation dose, absorption dose, illuminance, and the like, of EUV light, OoB light, and a total of both lights, for each reflecting mirror in a system in which the reflecting mirror M1 located closest to the mask surface along the light-propagation path from the mask surface to the wafer surface serves as a first reflecting mirror. The reflecting mirrors M3, M4, having low common-region percentages, and the reflecting mirrors M2, M5, M6 having high common-region percentages, serve as second reflecting mirrors. The OoB radiation dose on the wafer is 14.4 mW. This value is 13.7% of the 105 mW dose noted in Table 1 (in which all the reflecting mirrors M1-M6 are second reflecting mirrors), which represents a substantial reduction in the OoB dose. The total absorption by the reflecting mirror M3 is 6.7 mW/cm², which is less than the 8.1 mW/cm² noted for this reflecting mirror in Table 1. The total absorption by the reflecting mirror M4 having a low common-region percentage is 2.2 mW/cm², which is less than the 2.8 mW/cm² noted for this reflecting mirror in Table 1. Consequently, in the present embodiment, it is possible to reduce deformation, due to radiant heat, of the reflecting mirrors having low common-region percentages.

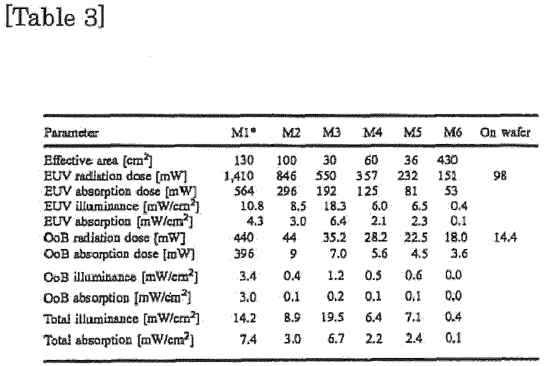

In a projection optical system according to a second embodiment, the reflecting mirrors M1, M2 have high respective common-region percentages and can accommodate deformations due to radiant heat. The reflecting mirrors M1, M2 are located, along the light-propagation path from the mask surface to the wafer surface, closer to the mask surface than the reflecting mirror M3 that has a low common-region percentage and is located closest to the mask surface among the reflecting mirrors having a low common-region percentage. The reflecting mirrors M1, M2 absorb OoB light in the manner of first reflecting mirrors. The reflecting mirrors M3, M4 have low respective common-region percentages and do not easily accommodate radiant-heat deformations. The reflecting mirrors M5, M6 have high respective common-region percentages and are located closer (along the light-propagation path) to the wafer surface than the reflecting mirror M3. The reflecting mirrors M3-M6 serve as second reflecting mirrors. The upstream reflecting mirrors M1, M2, serving as first reflecting mirrors, sufficiently absorb OoB light, which allows the downstream reflecting mirrors M5, M6 (having high respective common-region percentages) to serve as second reflecting mirrors. In this embodiment, the OoB radiation dosage on the wafer can be further reduced by increasing the number of first reflecting mirrors, relative to the first embodiment.

Table 4 lists data such as radiation dose, absorption dose, illuminance, and the like, of EUV light, OoB light, and of both lights, for each reflecting mirror of the system. Again, the reflecting mirrors M1, M2 located, along the light-propagation path from the mask surface to the wafer surface, closer to the mask surface than the reflecting mirror M3, serve as first reflecting mirrors. The remaining reflecting mirrors M3-M6 serve as second reflecting mirrors. The reflecting mirror M3 has a low common-region percentage and is located closest to the mask surface among the reflecting mirrors having a low common-region percentage. The reflecting mirrors M3, M4 have low respective common-region percentages, and the reflecting mirrors M5, M6 have high respective common-region percentages. The reflecting mirrors M5, M6 are the most downstream of the reflecting mirrors. The OoB radiation dose on the wafer is 2.0 mW, which is 1.9% of the 105 mW value noted in Table 1 (in which all the reflecting mirrors M1-M6 are second reflecting mirrors). This data in Table 4 represents a substantial reduction. The total absorption by the reflecting mirror M3 is 6.5 mW/cm², which is less than the 8.1 mW/cm² noted for this reflecting mirror in Table 1. The total absorption by the reflecting mirror M4 is 2.1 mW/cm² in Table 4, which is less than the 2.8 mW/cm² noted for this reflecting mirror in Table 1. These data show that it is possible to reduce deformation caused by absorption of radiant heat by reflecting mirrors having low respective common-region percentages.

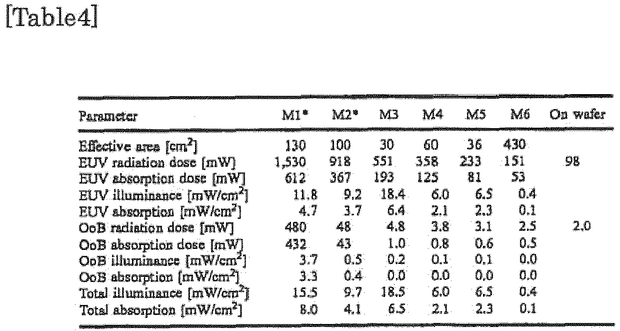

In a projection optical system according to a third embodiment of the present invention, the reflecting mirror M3 (that has the highest total illuminance in a system in which all the reflecting mirrors are second reflecting mirrors) is a second reflecting mirror. The other reflecting mirrors M1-M2, M4-M6 are first reflecting mirrors. When all the reflecting mirrors in the system are second reflecting mirrors, the reflecting mirror having the highest total illuminance is a reflecting mirror having a comparatively small effective reflecting region. The reflecting mirror having the highest total illuminance is also the reflecting mirror receiving the highest total absorption dose (absorption) per unit area and would be easily deformed by absorbed heat. Thus, the reflecting mirror M3 is a second reflecting mirror. Since the other reflecting mirrors M1-M2 and M4-M6 are first reflecting mirrors, the OoB radiation dosage on the wafer can be reduced compared to the first and second embodiments.

As previously discussed, in the projection optical system shown in FIG. 5, an intermediate image is formed in the vicinity of the reflecting mirror M3, between the reflecting mirrors M3 and M4. Consequently, the reflecting mirror M3 is also in the vicinity of the intermediate image. This is another reason the illuminance of this reflecting mirror is high, because the light beam converges in the vicinity of the location of the intermediate image.

Table 5 lists data such as radiation dose, absorption dose, illuminance, and the like, of EUV light, OoB light, as well as both lights, for each reflecting mirror of a system in which the reflecting mirror M3 (that would have the highest total illuminance in a system in which all the reflecting mirrors are second reflecting mirrors), is a second reflecting mirror while the other reflecting mirrors M1-M2, M4-M6 are first reflecting mirrors. The OoB radiation dose on the wafer is 0.005 mW, which is 0.0048% of the 105 mW dose noted in Table 1 (pertaining to a system in which all the reflecting mirrors M1-M6 are second reflecting mirrors). Thus, in this embodiment, the OoB dose on the wafer is substantially reduced. Also, the total absorption by the reflecting mirror M3 (having a low common-region percentage) is 8.1 mW/cm², which is equal to the 8.1 mW/cm² noted in Table 1. The total absorption by the reflecting mirror M4 (having a low common region percentage) is 3.1 mW/cm², which is slightly greater than the 2.8 mW/cm² noted in Table 1. Consequently, with this embodiment, it is possible to reduce deformation of reflecting mirrors (having low common-region percentages) due to radiant heat absorption to approximately the same level as exhibited by the system of Table 1.

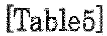

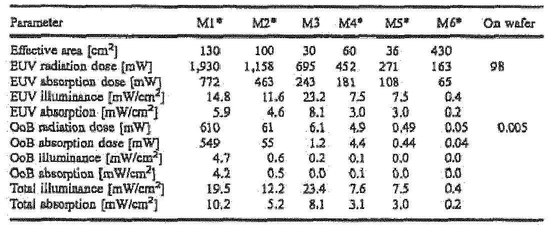

According to a fourth embodiment of the present invention, the reflecting mirrors M1, M2, M5, M6 (having high respective common-region percentages that can accommodate deformations caused by absorption of radiant heat) absorb OoB light as first reflecting mirrors. The remaining reflecting mirrors M3, M4 (having low respective common-region percentages that do not easily accommodate deformations caused by absorption of radiant heat) are second reflecting mirrors that absorb comparatively small amounts of light. Since the reflecting mirrors M3, M4 are second reflecting mirrors in this embodiment, radiant-heat deformation of reflecting mirrors having low respective common-region percentages is reduced.

Table 6 lists data such as radiation dose, absorption dose, illuminance, and the like, of EUV light, OoB light, as well as both lights, by each reflecting mirror of a system in which the reflecting mirrors M1, M2, M5, M6 (having high common-region percentages) are first reflecting mirrors, and the reflecting mirrors M3, M4 (having low common-region percentages) are second reflecting mirrors. The OoB radiation dose on the wafer is 0.04 mW, which is 0.038% of the 105 mW dose noted in Table 1 (in which all the reflecting mirrors M1-M6 of the system were second reflecting mirrors). Thus, this embodiment exhibits a substantial reduction of OoB dose on the wafer. Also, the total absorption by the reflecting mirror M3 (having a low common-region percentage) is 7.6 mW/cm², which is less than the 8.1 mW/cm² noted in Table 1. The total absorption by the reflecting mirror M4 (also having a low common-region percentage) is 2.5 mW/cm², which is lower than the 2.8 mW/cm² noted in Table 1. These data indicate the reduction of reflecting mirror deformation due to absorption of radiant heat by reflecting mirrors having low common-region percentages.

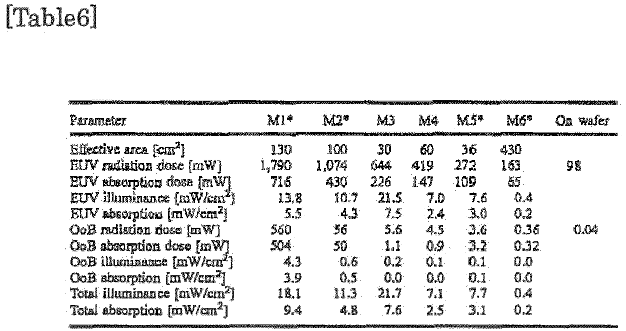

Thus, with the projection optical system according to the present invention, in which both first and second are combined, the OoB radiation dosage on a wafer can be reduced. Also reduced is any deterioration of optical properties of the projection optical system caused by deformation of constituent reflecting mirrors (having low common-region percentages) due to absorption of radiant heat.

An exposure system according to the invention comprises a projection optical system comprising first reflecting mirrors and second reflecting mirrors as discussed above. In some embodiments, a mask M can comprise a patterned absorbing layer disposed on the uppermost layer of the first reflecting mirror. When such a mask is used, any OoB light entering the projection optical system **37** is reduced more than in systems using a conventional reflective mask. This reduction of OoB light reduces thermal aberrations of the projection optical system and suppresses flare caused by OoB light, which yields improved resolving power of the system. In other embodiments the first reflecting mirror (as defined above) can be used as a reflecting mirror in an illumination-optical system. Also, although the embodiments described above are set forth in the context of the projection optical system as used in exposure systems utilizing EUV light as exposure light, the principles of the invention alternatively can be applied to a projection optical system and other optical systems of exposure apparatus using light of other wavelengths, rather than EUV light, as exposure light.

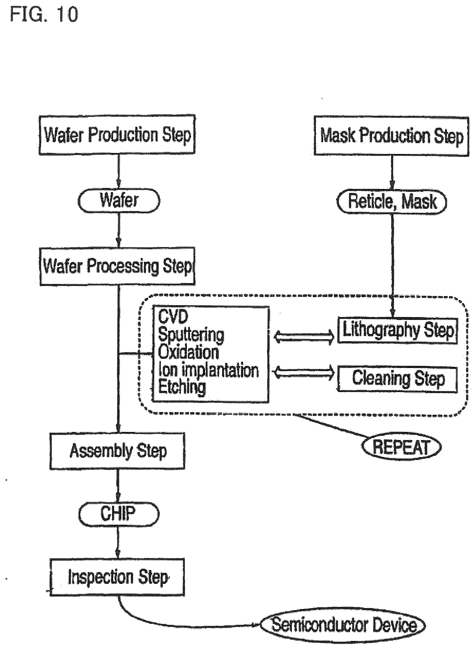

An exemplary semiconductor device manufacturing method according to an embodiment of the invention, will be described below. FIG. 10 is a flowchart of an exemplary semiconductor device manufacturing method according to an embodiment of the invention. The manufacturing method generally comprises the following main steps.
(1) wafer production (wafer manufacturing or preparation)
(2) production or preparation of a mask which is used for exposure
(3) wafer processing for exposure of wafer
(4) chip assembly including dicing of chips and rendering the chips operational
(5) chip inspection.

Each step usually comprises several sub-steps.

Among the main steps, wafer processing is key to achieving the smallest feature sizes (critical dimensions) and best inter-layer registration. In the wafer-processing step, multiple circuit patterns are layered successively atop one another on the wafer, forming multiple chips destined to be memory chips or main processing units (MPUs). Typical wafer-processing steps include:
(1) thin-film formation (by, e.g., sputtering or CVD) involving formation of a dielectric layer for electrical insulation or a metal layer for connecting wires or electrodes;
(2) oxidation step to oxidize the wafer substrate or the thin-film layer previously formed;
(3) microlithography to form a resist pattern for selective processing of the thin film or the wafer substrate itself;
(4) etching or analogous step (e.g., dry-etching) to etch the thin film or substrate according to the resist pattern;
(5) doping as required to implant ions or impurities;
(6) resist stripping; and
(7) wafer inspection to inspect the etched wafer.

Wafer processing is repeated as required to fabricate the desired semiconductor devices.

In the embodiment an exposure apparatus according to the invention is used in the step of microlithography. Consequently, in the exposure apparatus thermal aberrations of the projection optical system are reduced and flare caused by OoB light is suppressed. Thus, resolving power of the system is improved and therefore a semiconductor device can be manufactures with higher accuracy.

### Embodiments

### Embodiment 1.

A projection optical system for projecting an image of a pattern from a first plane onto a second plane, the system comprising:
a first reflecting mirror and a second reflecting mirror, wherein the first reflecting mirror has a reflectance, for light of a predetermined wavelength, that is less than a predetermined reflectance and the second reflecting mirror has a reflectance, for light of the predetermined wavelength, that is greater than the predetermined reflectance;
characterized in that along a light-propagation path from the first plane to the second plane the first reflecting mirror is situated closer than the second reflecting mirror to the first plane.

### Embodiment 2.

The system of embodiment 1, further comprising at least one additional reflecting mirror, wherein, along the light-propagation path from the first plane to the second plane, the first reflecting mirror is closest to the first plane.

### Embodiment 3.

A projection optical system for projecting an image of a pattern from a first plane onto a second plane, the system comprising:
a first reflecting mirror and a second reflecting mirror, wherein the first reflecting mirror has a reflectance, for light of a predetermined wavelength, that is less than a predetermined reflectance and the second reflecting mirror has a reflectance, for light of the predetermined wavelength, that is greater than the predetermined reflectance;
characterized in that along a light-propagation path from the first plane to the second plane the second reflecting mirror is situated at a location of maximal illuminance.

### Embodiment 4.

The system of embodiment 3, further comprising at least one additional reflecting mirror, wherein along the light-propagation path from the first plane to the second plane at least one reflecting mirror among reflecting mirrors situated closer to the first plane than the second reflecting mirror situated at the location of maximal illuminance is the first reflecting mirror.

### Embodiment 5.

The system of embodiment 3, further comprising at least one additional reflecting mirror, wherein, along the light-propagation path from the first plane to the second plane, the reflecting mirror situated closest to the first plane is the first reflecting mirror.

### Embodiment 6.

The system of embodiment 3, further comprising at least one additional reflecting mirror, wherein, along the light-propagation path from the first plane to the second plane, all the reflecting mirrors situated closer than the second reflecting mirror at the location of maximal illuminance to the first plane are first reflecting mirrors.

### Embodiment 7.

A projection optical system for projecting an image of a pattern from a first plane onto a second plane, the system comprising:
a first reflecting mirror and a second reflecting mirror, wherein the first reflecting mirror has a reflectance, for light of a predetermined wavelength, that is less than a predetermined reflectance and the second reflecting mirror has a reflectance, for light of the predetermined wavelength, that is greater than the predetermined reflectance;
characterized in that along a light-propagation path from the first plane to the second plane the second reflecting mirror is situated in a vicinity of a location at which an intermediate image of the pattern is formed by the system.

### Embodiment 8.

The system of embodiment 7, further comprising at least one additional reflecting mirror, wherein along the light-propagation path from the first plane to the second plane at least one reflecting mirror among reflecting mirrors situated closer to the first plane than the second reflecting mirror situated in a vicinity of a location at which an intermediate image of the pattern is formed is the first reflecting mirror.

### Embodiment 9.

The system of embodiment 7, further comprising at least one additional reflecting mirror, wherein, along the light-propagation path from the first plane to the second plane, the first reflecting mirror is situated closest to the first plane.

### Embodiment 10.

The system of embodiment 7, wherein, along the light-propagation path from the first plane to the second plane, all the reflecting mirrors situated closer than the second reflecting mirror situated in a vicinity of a location at which an intermediate image of the pattern is formed, to the first plane are first reflecting mirrors.

### Embodiment 11.

A projection optical system for projecting an image of a pattern from a first plane onto a second plane, the system comprising:
a first reflecting mirror and a second reflecting mirror, wherein the first reflecting mirror has a reflectance, for light of a predetermined wavelength, that is less than a predetermined reflectance and the second reflecting mirror has a reflectance, for light of the predetermined wavelength, that is greater than the predetermined reflectance;, wherein with respect to each of the reflecting mirrors of the system, a first point-reflecting region is a region, on the reflecting mirror, at which a light beam collected at a predetermined first point on the second plane is reflected, a second point-reflecting region is a region, on the reflecting mirror, at which a light beam collected at a second point, different from the first point, on the second plane is reflected, and a common-reflecting region is a region, on the reflecting mirror, in which the first point-reflecting region and the second point-reflecting region overlap;
characterized in that of the multiple reflecting mirrors of the system, a subset comprises reflecting mirrors each having a respective common-reflection region in which a portion corresponding to the first point-reflecting region is lower than a predetermined percentage; and among the reflecting mirrors in the subset the reflecting mirror closest to the first plane along the light-propagation path from the first plane to the second plane, is the second reflecting mirror.

### Embodiment 12.

The system of embodiment 11, further comprising at least one additional reflecting mirror, wherein along the light-propagation path from the first plane to the second plane at least one reflecting mirror among reflecting mirrors situated closer to the first plane than the second reflecting mirror closest to the first plane in the subset is the first reflecting mirror.

### Embodiment 13.

The system of embodiment 11, further comprising at least one additional reflecting mirror, wherein, along the light-propagation path from the first plane to the second plane, the first reflecting mirror is situated closest to the first plane.

### Embodiment 14.

The system of embodiment 11, wherein, along the light-propagation path from the first plane to the second plane, all the reflecting mirrors situated closer than the second reflecting mirror closest to the first plane in the subset, to the first plane are first reflecting mirrors.

### Embodiment 15.

The system of embodiment 11, wherein all reflecting mirrors, having respective common-reflection regions in which respective portions corresponding to the first point-reflecting region are lower than the predetermined percentage, are second reflecting mirrors.

### Embodiment 16.

The system of embodiment 11, wherein at least one of the reflecting mirrors, having respective common-reflection regions in which respective portions corresponding to the first point-reflecting region are higher than the predetermined percentage, is a first reflecting mirror.

### Embodiment 17.

The system of embodiment 11, wherein all reflecting mirrors, having respective common-reflection regions in which respective portions corresponding to the first point-reflecting region are higher than the predetermined percentage, are first reflecting mirrors.

### Embodiment 18.

The system of embodiment 11, further defining an arc-shaped exposure region of a predetermined width, wherein: the first point-reflection region is a first end of an arc passing through a widthwise center of the arc-shaped exposure region; the second point-reflection region is a second end of the arc passing through the widthwise center of the arc-shaped exposure region;
characterized in that among the reflecting mirrors having respective common-reflection regions in which respective portions corresponding to the first point-reflecting region are lower than the predetermined percentage, the reflecting mirror situated closest, along the light-propagation path from the first plane to the second plane, to the first plane is a second reflecting mirror.

### Embodiment 19.

The system of embodiment 18, wherein among the reflecting mirrors of which the percentage of the common-reflection region corresponding to the first point-reflecting region is zero, the reflecting mirror situated closest, along the light-propagation path from the first plane to the second plane, to the first plane is the second reflecting mirror.

### Embodiment 20.

The system of any one of embodiments 1 to 19, configured to use exposure light, having a wavelength different from the predetermined wavelength, for projecting an image of the pattern on the first plane onto the second plane, wherein the predetermined reflectance is reflectance to the exposure light.

### Embodiment 21.

A projection optical system for projecting an image of a pattern from a first plane onto a second plane, characterized in that the system comprises a first reflecting mirror having a particular reflectance for light of a predetermined wavelength; and a second reflecting mirror having a reflectance, greater than the reflectance of the first reflecting mirror, for light of the predetermined wavelength.

### Embodiment 22.

The system of embodiment 21, wherein the first reflecting mirror is situated, along the light-propagation path from the first plane to the second plane, closer than the second reflecting mirror to the first plane.

### Embodiment 23.

The system of embodiment 21, wherein the first reflecting mirror is situated, along the light-propagation path from the first plane to the second plane, closest to the first plane.

### Embodiment 24.

The system of embodiment 21, wherein illuminance at the first reflecting mirror is less than illuminance at the second reflecting mirror.

### Embodiment 25.

The system of embodiment 21, wherein the second reflecting mirror is situated at a location at which illuminance is highest.

### Embodiment 26.

The system of embodiment 21, wherein the second reflecting mirror is located, along the light-propagation path from the first plane to the second plane, in the vicinity of the intermediate-image location.

### Embodiment 27.

The system of embodiment 21, wherein, with respect to each of the reflecting mirrors of the system; a first point-reflecting region is a region, on the reflecting mirror, at which a light beam collected at a predetermined first point on the second plane is reflected; a second point-reflecting region is a region, on the reflecting mirror, at which a light beam collected at a second point, different from the first point, on the second plane is reflected; a common-reflecting region is a region, on the reflecting mirror, in which the first point-reflecting region and the second point-reflecting region overlap; a common-region percentage is the percentage of the common-reflecting region corresponding to the first point-reflecting region; and the common-region percentage of the first reflecting mirror is higher than the common-region percentage of the second reflecting mirror.

### Embodiment 28.

The system of embodiment 27, further defining an arc-shaped exposure region of a predetermined width, wherein: the first point is a first end of an arc passing through a widthwise center of the arc-shaped exposure region; the second point is a second end of the arc passing through the widthwise center of the arc-shaped exposure region; and the common-region percentage of the first reflecting mirror is higher than the common-region percentage of the second reflecting mirror.

### Embodiment 29.

The system of embodiment 28, wherein among the reflecting mirrors of which the percentage of the common-region percentage is zero, the reflecting mirror situated closest, along the light-propagation path from the first plane to the second plane, to the first plane is a second reflecting mirror.

### Embodiment 30.

The system of any one of embodiments 21 to 29, configured to use exposure light, having a wavelength different from the predetermined wavelength, for projecting an image of the pattern on the first plane onto the second plane.

### Embodiment 31.

The system of embodiment 20 or embodiment 30, wherein the exposure light is EUV light.

### Embodiment 32.

A projection optical system for projecting an image of a pattern from a first plane onto a second plane for exposure, the system comprising plural reflecting mirrors for reflecting exposure light between the first plane and the second plane,
characterized in that the reflecting mirrors comprise a first reflecting mirror which has a mechanism to reduce lights having a wavelength different from the exposure light and reaching a reflecting mirror situated on the second plane side along a light-propagation path from the first plane to the second plane or the second plane and a second reflecting mirror which does not have the mechanism and
along the light-propagation path from the first plane to the second plane, the first reflecting mirror is closest to the first plane is.

### Embodiment 33.

The system of any one of embodiments 1 to 32, wherein a reflectance of the first reflecting mirror for the light of the wavelength is less than a half of a reflectance of the first reflecting mirror for the light of the wavelength.

### Embodiment 34.

The system of any one of embodiments 1 to 33, wherein the first reflecting mirror has a layer for absorbing the light of the wavelength.

Embodiment 35. The system of any one of embodiments 1 to 34, wherein the first reflecting mirror has a multilayer-film and a layer for absorbing the light of the wavelength provided on the multilayer-film.

### Embodiment 36.

The system of embodiment 34 or embodiment 35, wherein the layer for absorbing the light of the wavelength is made of any of or any combination of silicon oxide, carbon, zirconium, silicon carbide, silicon nitride, boron carbide, and boron nitride.

### Embodiment 37.

The system of any one of embodiments 1 to 33, wherein the first reflecting mirror has a multilayer-film and an additional layer or a membrane provided on the multilayer-film and a reflective surface of the multilayer-film is inclined relative to a reflective surface of the additional layer or membrane.

### Embodiment 38.

The system of embodiment 37, wherein the additional layer or membrane is made of any of or any combination of silicon, silicon carbide, and silicon nitride.

### Embodiment 39.

An exposure apparatus comprising a projection optical system according to any one of embodiments 1 to 38.

### Embodiment 40.

A method for manufacturing a semiconductor device, having a process in which exposure for transfer is performed using the exposure apparatus according to embodiment 39.

## Claims

1. An exposure apparatus configured to expose a pattern onto a substrate with an EUV light, the exposure apparatus comprising:
a first reflecting mirror arranged on an optical path of the EUV light;
a second reflecting mirror arranged on an optical path of the EUV light defined between the first reflecting mirror and the substrate, wherein
a reflectance of the first reflecting mirror with respect to a light having a wavelength different from a wavelength of the EUV light is smaller than a reflectance of the second reflecting mirror with respect to the light having the wavelength different from the wavelength of the EUV light.

2. The exposure apparatus according to claim 1, wherein a reflectance of the first reflecting mirror with respect to the EUV light is smaller than a reflectance of the second reflecting mirror with respect to the EUV light.

3. The exposure apparatus according to claim 1 or 2, wherein the reflectance of the first reflecting mirror with respect to the light having the wavelength different from the wavelength of the EUV light is smaller than a reflectance of the first reflecting mirror with respect to the EUV light.

4. The exposure apparatus according to claim 3, wherein the reflectance of the first reflecting mirror with respect to the light having the wavelength different from the wavelength of the EUV light is 0% to 40% of the reflectance of the first reflecting mirror with respect to the EUV light.

5. The exposure apparatus according to claim 3, wherein the reflectance of the first reflecting mirror with respect to the light having the wavelength different from the wavelength of the EUV light is 0% to 10% of the reflectance of the first reflecting mirror with respect to the EUV light.

6. The exposure apparatus according to any one of claims 1 to 5, wherein the first reflection mirror including:
a base member;
an EUV light-reflecting film provided on the base member so as to reflect the EUV light; and
a light-absorbing film provided on the EUV light-reflecting film so as to absorb the light having the wavelength different from the wavelength of the EUV light.

7. The exposure apparatus according to claim 6, wherein a thickness of the light-absorbing film is 1nm to 50 nm.

8. The exposure apparatus according to claim 6 or 7, wherein the light-absorbing film suppresses oxidation of the EUV light-reflecting film.

9. The exposure apparatus according to any one of claims 1 to 8, further comprising:
an illumination optical system configured to illuminate an object with the EUV light; and
a projection optical system configured to project an image of the object onto the substrate.

10. The exposure apparatus according to claim 9, wherein the projection optical system has a plurality of reflecting mirrors in which the first and second reflecting mirrors are included.

11. The exposure apparatus according to claim 10, wherein the projection optical system forms an intermediate image of the object, a position at which the second reflecting mirror is arranged is the nearest to the intermediate image, among positions at which the plurality of reflecting mirrors of the projection optical system are arranged respectively.

12. The exposure apparatus according to claim 10 or 11, wherein a position at which the first reflecting mirror is arranged is the nearest to a plane on which the object is arranged, among positions at which the plurality of reflecting mirrors of the projection optical system are arranged respectively.

13. The exposure apparatus according to any one of claims 9 to 12, wherein the illumination optical system includes the first reflecting mirror.

14. A device manufacturing method comprising:
transferring a pattern onto a substrate by using the exposure apparatus as defined in any one of claims 1 to 13; and
processing the substrate onto which the pattern has been transferred.
